Europäisches Patentamt

European Patent Office

Office européen des brevets

(19)

(11) Publication number : **0 483 080 A1**

(12) # EUROPEAN PATENT APPLICATION

(21) Application number : **91830434.6**

(22) Date of filing : **15.10.91**

(51) Int. Cl.⁵ : **H01L 23/40**

(30) Priority : **22.10.90 IT 5332290 U**

(43) Date of publication of application :
**29.04.92 Bulletin 92/18**

(84) Designated Contracting States :
**DE ES FR GB SE**

(71) Applicant : **MARELLI AUTRONICA S.p.A.**
**Via Griziotti 4**
**I-20145 Milano (IT)**

(72) Inventor : **Dolcet, Edoardo**
**Via Crimea 20**
**I-10098 Rivoli, (Torino) (IT)**

(74) Representative : **Quinterno, Giuseppe et al**
**c/o Jacobacci-Casetta & Perani S.p.A. Via**
**Alfieri, 17**
**I-10121 Torino (IT)**

(54) **A device for fastening electronic power components to a heatsink.**

(57)   The device comprises a small bar (12) of polymeric material provided with means (20, 22) for clamping components (C) against the dissipator (D) and a lateral rebate (14) in correspondence with which the components (C) are clamped against the heat dissipator (D).

FIG. 2

EP 0 483 080 A1

The present invention relates to a device for fixing electronic power components to a heat dissipator.

The fixing of electronic power components, for example transistors, to a heat dissipator, a finned plate or an integral part of a metal container in which there is an electronic monitoring unit requires an intimate contact between the component and the dissipator in order to allow optimum transmission of the heat.

The problem of providing an optimum contact between power components and dissipator is resolved according to the present invention by virtue of a bar of polymeric material provided with means for clamping it against the dissipator and a lateral rebate in correspondence with which the power components are clamped against the heat dissipator.

Preferably, the bar includes in correspondence with the lateral rebate a plurality of transverse notches disposed substantially between the power components and adapted to allow a distribution of the clamping pressures of the components.

By virtue of these characteristics, it is possible to exploit the elastic properties of the bar of polymeric material which will resist high temperatures and to which a mineral filler has been added.

Further advantages and characteristic features of the fixing device according to the invention will become evident from the following detailed description which is given purely by way of non-limitative example, reference being made to the attached drawings, in which:

Figure 1 is a partially sectional front view of a device according to the invention,

Figure 2 is a sectional view taken on the line II-II in Figure 1 and

Figure 3 is an exploded perspective view of the device in Figures 1-2.

With reference to the drawings, reference numeral 10 generally designates a device for fixing electronic power components C, for example power transistors, to a heat dissipator D. The device comprises a prismatic bar 12 of quadrangular cross-section, made from polymeric material with a mineral filler in order to withstand high temperatures and having in one of its lateral walls 12a a rebate 14 against which are clamped the portions $C_1$ of the power components C. The bar 12 also has a series of transverse notches 16 disposed at right-angles to the rebate 14 between the power components C and, in correspondence with each clamping zone of the relative power component C, a transverse bore 18 which is disposed substantially between two adjacent notches 16.

The bar 12 has in correspondence with the ends 12a two fixing holes 20 adapted to cooperate with screws 22 for clamping the bar 12 against the surface S of the metal heat dissipator D which, in the form of embodiment shown in the drawings, corresponds to the walls of a metal container A housing the electronic monitoring unit (not illustrated) of which the power components C form part.

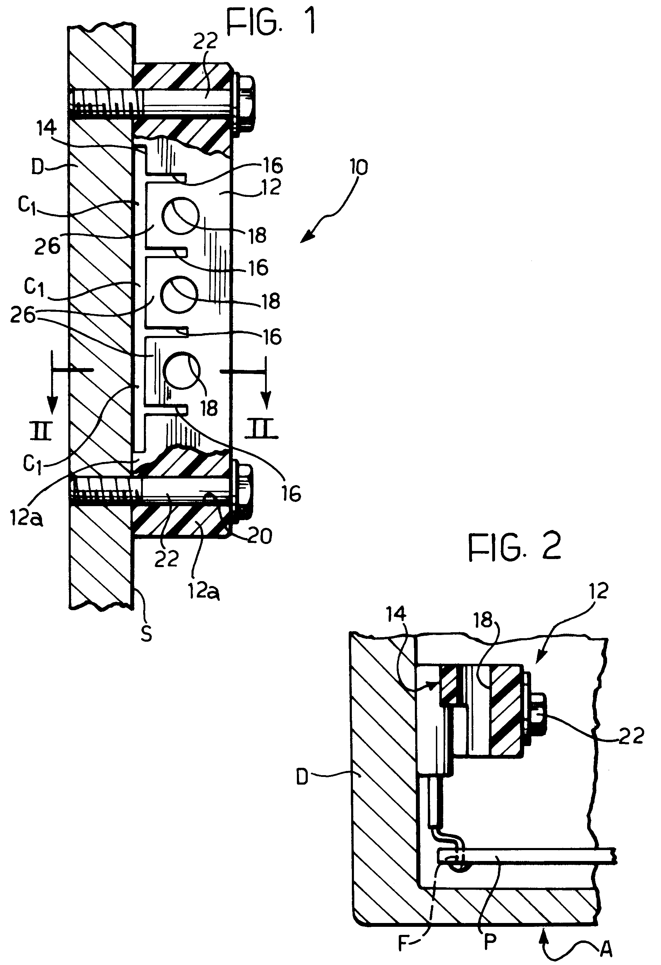

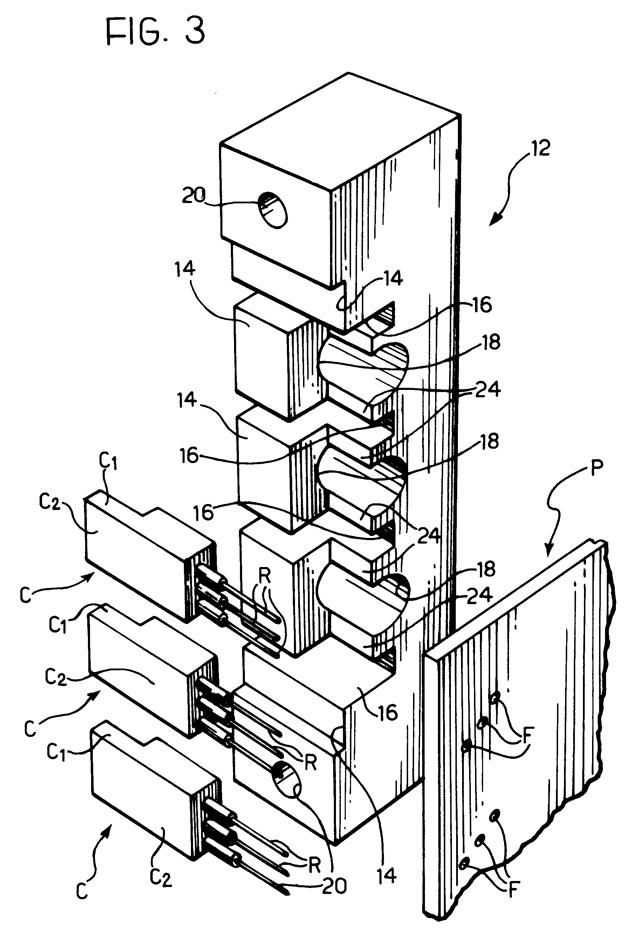

Each of the said components has a portion $C_2$ adjacent the clamping portion $C_1$ placed on a step 24 formed in the rebate 14 between pairs of notches 16 (Figures 2-3) and the rheophores R of each power component C are inserted into appropriate bores F in a printed circuit board P disposed in the container A.

The presence of the notches 16 makes it possible to obtain a good distribution of clamping pressures over the components C. The transverse bores 18 in the bar 12 is correspondence with the components C integrate the function of the notches 16 by guaranteeing elasticity in the clamping of the components, an elasticity which is due to the reversed arc conformation of zones 26 of the bar which are capable of clamping the portions $C_1$ of the power components C.

Naturally, it is understood that the scope of the present invention extends to models which achieve equal usefulness, employing the same innovative concept.

## Claims

1. A device for fixing electronic power components to a heat dissipator, characterised in that it comprises a bar (12) of polymeric material provided with means (20, 22) for clamping it against the dissipator (D) and a lateral rebate (14) in correspondence with which the power components (C) are clamped against the heat dissipator (D).

2. A device according to Claim 1, characterised in that the bar (12) has in correspondence with the rebate (14) a plurality of transverse notches (16) disposed substantially between the power components (C) and adapted to allow a distribution of the clamping pressures of the components (C).

3. A device according to Claim 1 or Claim 2, characterised in that the bar (12) has a plurality of transverse through-bores (18) each disposed substantially in correspondence with a clamping zone (26) of a respective power component (C) in order to allow an elastic flexion of such clamping zones (26).

4. A device according to Claim 3, characterised in that the means for clamping the bar (12) to the dissipator (T) comprise a pair of screws (22) adapted to cooperate with two fixing bores (20) at right-angles to the through-bores (18) in the bar (12) and disposed substantially at the ends (12a) of the said bar.

5. A device according to any one of the preceding claims, characterised in that the polymeric material constituting the bar includes a mineral filler.

# FIG. 1

# FIG. 2

# FIG. 3

**European Patent Office**

# EUROPEAN SEARCH REPORT

Application Number

EP 91 83 0434

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | EP-A-0 254 692 (SGS MICROELETTRONICA)<br>* column 5, line 18 - line 42 *<br>* claim 1; figure 2 * | 1,2 | H01L23/40 |
| A | | 4 | |
| | ----- | | |
| | | | |
| | | | **TECHNICAL FIELDS SEARCHED (Int. Cl.5)** |
| | | | H01L |

The present search report has been drawn up for all claims

| Place of search | Date of completion of the search | Examiner |
|---|---|---|
| THE HAGUE | 28 JANUARY 1992 | DE RAEVE R.A.L. |